# EUROPEAN PATENT APPLICATION

(11) **EP 4 648 114 A1**
(43) Date of publication of application: **12.11.2025**
(21) Application number: 23914972.7
(22) Date of filing: 15.12.2023
(51) Int. Cl.: H01L 31/18, H01L 21/687

(54) **BOAT APPARATUS**

(30) Priority: 02.01.2023 KR 20230000372
(71) Applicant: Hanwha Solutions Corporation, Seoul 04541 (KR)
(72) Inventor: HAN, Jong Kuk, Seoul 04541 (KR); LEE, Jae Cheol, Seoul 04541 (KR); LIM, Jae Yong, Seoul 04541 (KR)
(74) Representative: Mooser, Sebastian Thomas
(86) International application number: PCT/KR2023/020717
(87) International publication number: WO 2024/147510

(57) **Abstract**

The present invention relates to a boat apparatus having a first groove in an electrode block in order to prevent component damage and increase production of solar cells. Disclosed in one embodiment of the present invention is a boat apparatus comprising: a plurality of electrode plates spaced apart from each other and having a plurality of substrates stacked therebetween; a plurality of electrode blocks that support electrode plates of the same polarity among the plurality of electrode plates and have first grooves on both sides contacting the electrode plates; and a fixing part fastened through the plurality of electrode plates and the plurality of electrode blocks.

## Description

### [Technical Field]

The present invention relates to a boat apparatus, and more particularly, to a boat apparatus including an electrode block having a first groove.

### [Background Art]

Solar cells convert light energy of the sun into electrical energy. Solar power generation using solar cells is classified as a type of renewable energy generation that does not use existing fossil fuels. Solar cells have a structure in which a negative (N) type semiconductor and a positive (P) type semiconductor are joined, and a boundary between the two semiconductors is referred to as a PN junction.

When solar cells are manufactured, there is a process of inputting a substrate (wafer) into a chamber and forming PN junctions in the substrate through a deposition process such as a plasma enhanced chemical vapor deposition (PECVD) process in the chamber. A boat apparatus is an apparatus that supports the substrate in the chamber during such a process.

In the past, there has been a problem in that some parts of a boat apparatus are damaged due to an impact and vibrations generated during a process of transporting the boat apparatus into a chamber. Specifically, the problem is as follows.

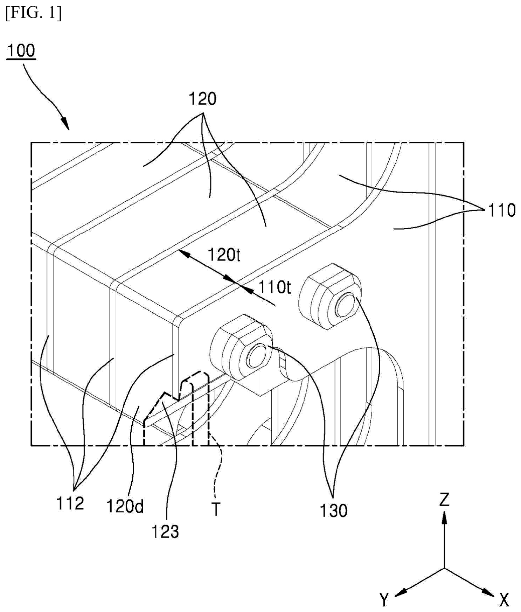

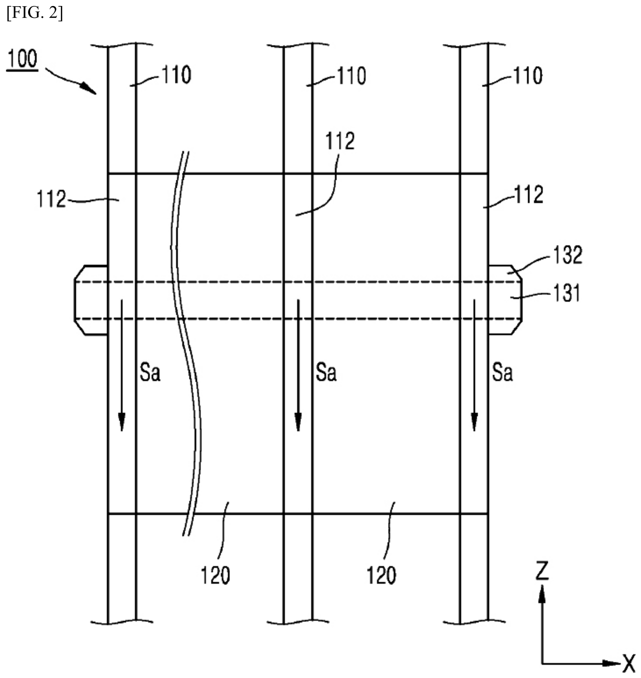

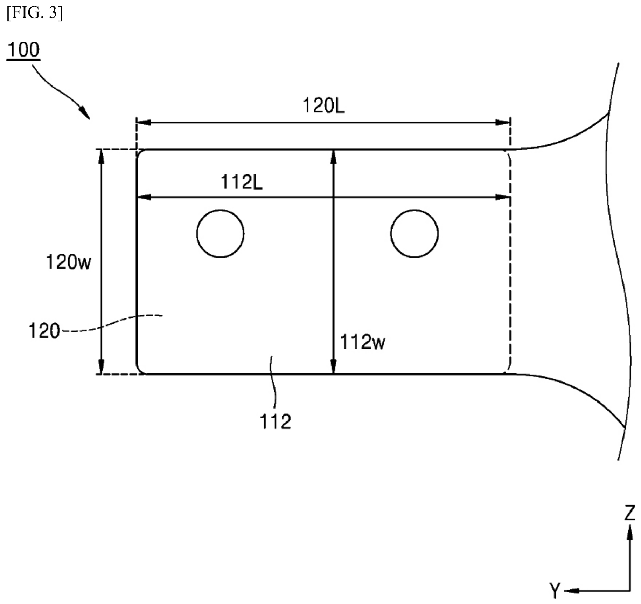

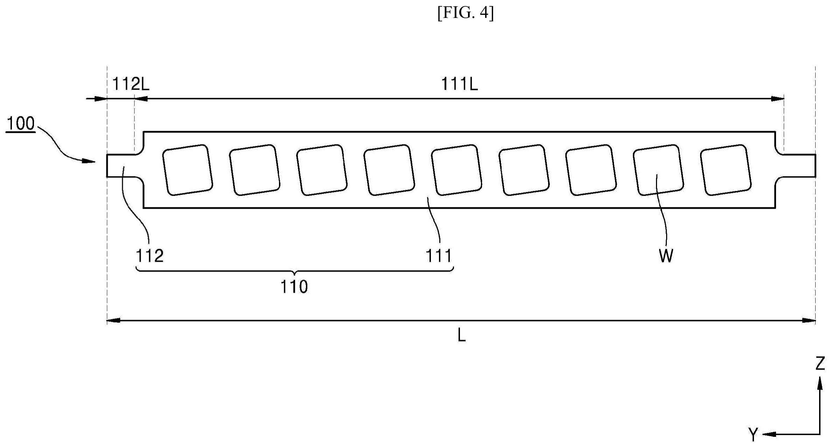

FIG. 1 is a view illustrating a part of a conventional boat apparatus 100. FIG. 2 is a view illustrating a magnitude of shear load applied to a fixing part in the case of the conventional boat apparatus 100. FIG. 3 is a view illustrating an area of a portion 112 with which an electrode plate and electrode block 120 are in contact in the conventional boat apparatus 100. FIG. 4 is a view illustrating an example of the number of substrates loaded on the electrode plate in the conventional boat apparatus 100.

Referring to FIG. 1, in the conventional boat apparatus 100, an electrode plate 110 and the electrode block 120 are fixed and supported only by a fixing part 130.

Referring to FIG. 2, in the conventional boat apparatus 100, the entire weight of the electrode plate 110 is applied to a rod 131. Therefore, the entire weight of the electrode plate 110 acts as a shear load Sa on the fixing rod 131. Accordingly, there are cases in which the fixing rod 131 is damaged.

In addition, in the case of the conventional boat apparatus 100, even when the electrode block 120 and the electrode plate 110 are fixed in close contact with each other by a fixing bolt 132, the fastening between the fixing bolt 132 and the fixing rod 131 may become loose due to vibrations or the like during a process of lifting and moving the boat apparatus to a chamber. In this case, a space may be generated between the electrode block 120 and the electrode plate 110, and an impact due to friction or collision may occur between the electrode block 120 and the electrode plate 110.

Meanwhile, referring to FIGS. 1 and 3, in order for the fixing part 130 to support the electrode plate 110 and the electrode block 120 as stably as possible, the entirety of one surface of the electrode block 120 may be in contact with one end portion of the electrode plate 110. Accordingly, as shown in FIG. 4, when a total length L of the electrode plate is constant, a space 111 in which the substrate W may be loaded is limited due to an area of a portion 112 of the electrode plate 110 in contact with the electrode block 120.

The information in the background art described above was obtained by the inventors for the purpose of developing the present invention or was obtained during the process of developing the present invention. As such, it is to be appreciated that this information did not necessarily belong to the public domain before the patent filing date of the present invention.

### [Detailed Description of Invention]

### [Technical Problem]

The present invention is intended to solve the above problems and is directed to providing a boat apparatus in which a first groove is formed in an electrode block to prevent damage to a fixing part due to shear load during a process of transporting the boat apparatus.

The present invention is also directed to providing a boat apparatus in which an area of a portion of an electrode plate in contact with an electrode block is decreased, thereby increasing an area in which a substrate may be loaded on an electrode plate.

However, the objects are exemplary, and the objects to be solved by the present invention are not limited thereto.

### [Technical Solution]

One embodiment of the present invention provides a boat apparatus including a plurality of electrode plates which are disposed to be spaced apart from each other and between which a plurality of substrates are loaded, a plurality of electrode blocks which support a plurality of electrode plates having the same polarity among the plurality of electrode plates and each have a first groove, which is in contact with one of the plurality of electrode plates having the same polarity, formed in each of opposite surfaces of the electrode block; and a fixing part fastened to pass through the plurality of electrode plates and the plurality of electrode blocks.

In the present embodiment, the opposite surfaces of the electrode block with which the electrode plates may be in contact may be symmetrical to each other.

In the present embodiment, the electrode plate may further include a contact portion inserted into the first groove and supported by the electrode block, and the electrode block may further include a protrusion configured to form a step with the first groove and support the contact portion.

In the present embodiment, an end portion of the contact portion may be disposed inside the electrode block.

In the present embodiment, an area of the contact portion may be smaller than an area of the first groove.

In the present embodiment, a length of the contact portion may be 0.5 times or more a length of the first groove.

In the present embodiment, the protrusion may be provided as a plurality of protrusions, wherein each protrusion is formed at one of an upper end portion and a lower end portion of the electrode block, and the contact portion may be fixedly interposed between the plurality of protrusions.

In the present embodiment, a length of the protrusion may be 0.5 times or less a thickness of the contact portion.

In the present embodiment, at least one electrode block among the plurality of electrode blocks may further include a support supported on a device configured to move the boat apparatus.

In the present embodiment, the electrode block may include one or more second grooves which are each formed in one of opposite surfaces of the electrode block having the first groove, vertically meets the first groove, and is connected to a point of the electrode block through which the fixing part passes.

Other aspects, features, and advantages other than those described above will become apparent from the following detailed description, claims and drawings for embodying the present invention.

### [Advantageous Effects]

In a boat apparatus according to one embodiment of the present invention, since an electrode block has a first groove, the electrode block can support an electrode plate, and thus a magnitude of shear load applied to a fixing rod by the weight of the electrode plate can be reduced, thereby preventing damage to a fixing part.

In addition, since an electrode block has a first groove, even when the fastening between a fixing bolt and a fixing rod becomes loose due to vibration or the like when a boat apparatus is moved, an electrode plate can be fixed to the electrode block, and thus an impact due to friction or collision between the electrode block and the electrode plate can be reduced, thereby preventing damage to the electrode block and the electrode plate.

In an boat apparatus according to one embodiment of the present invention, since an area of a contact portion is smaller than an area of a first groove, more substrates can be loaded on an electrode plate, and thus the number of substrates that can be transported at one time by the boat apparatus can be increased, thereby increasing a production amount of solar cells.

In addition, when a device for moving a boat apparatus picks up and lifts a boat apparatus, the device is in contact with only a support formed on an electrode block and is not in contact with an electrode plate, thereby preventing damage to the electrode plate.

### [Description of Drawings]

FIG. 1 is a view illustrating a part of a conventional boat apparatus.
FIG. 2 is a view illustrating a magnitude of shear load applied to a fixing part in the case of the conventional boat apparatus.
FIG. 3 is a view illustrating an area of a portion with which an electrode plate and electrode block are in contact in the conventional boat apparatus.
FIG. 4 is a view illustrating an example of the number of substrates loaded on the electrode plate in the conventional boat apparatus.

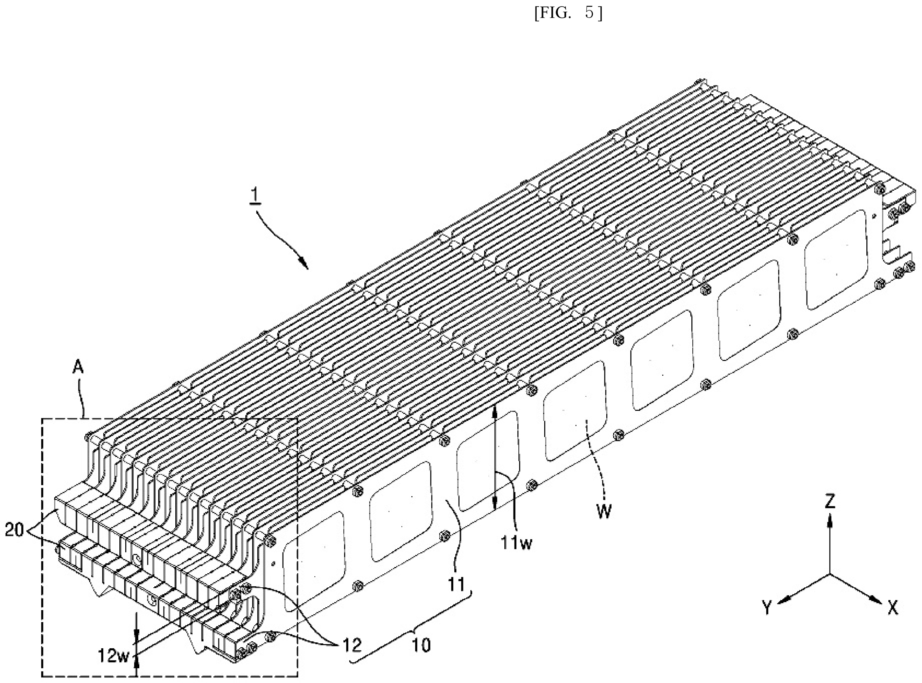

FIG. 5 is a perspective view illustrating a boat apparatus according to one embodiment of the present invention.

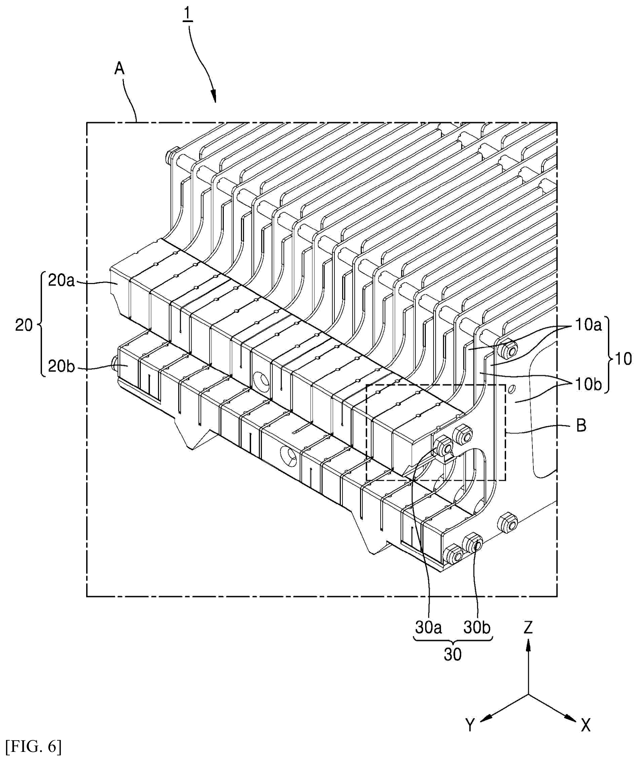

FIG. 6 is an enlarged perspective view of part A of FIG. 5 which illustrates an end portion of the boat apparatus 1 according to one embodiment of the present invention.

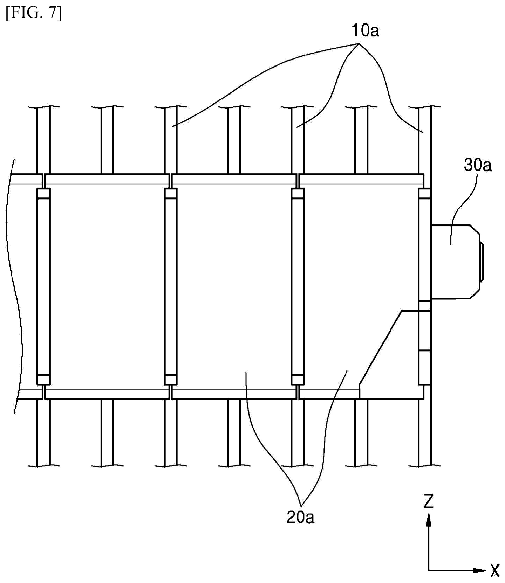

FIG. 7 is a view illustrating some of a plurality of electrode blocks and some of a plurality of electrode plates which have the same polarity and are connected thereto.

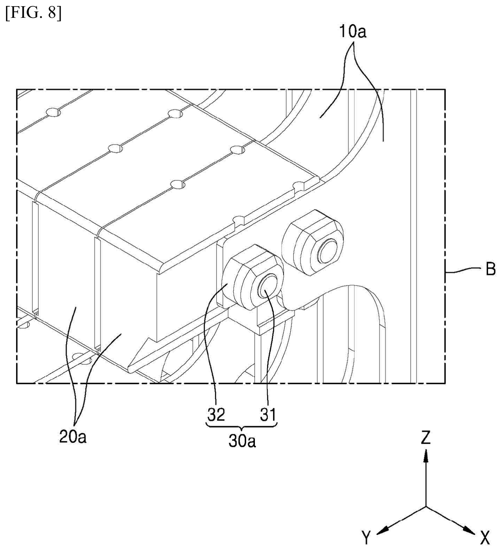

FIG. 8 is an enlarged perspective view of part B of FIG. 6 which illustrates the electrode plate, the electrode block, and a fixing part.

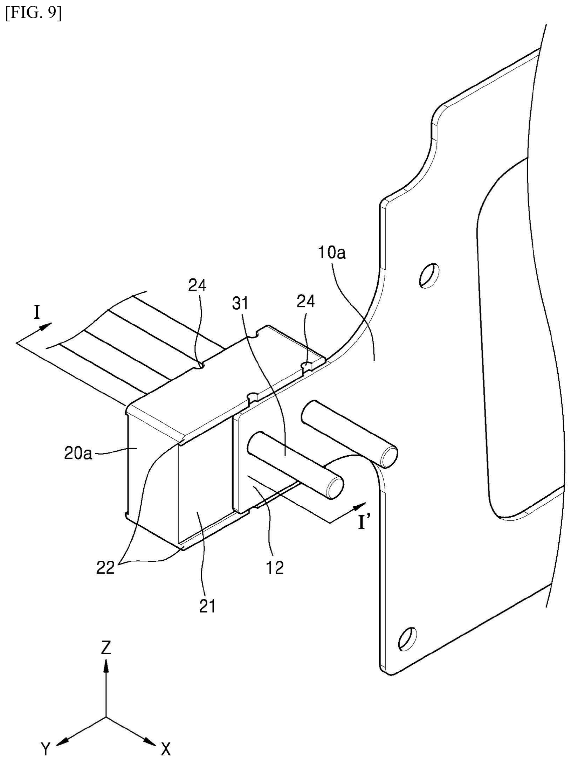

FIG. 9 is a view illustrating a structure in which one electrode plate among the plurality of electrode plates is connected to one electrode block among the plurality of electrode blocks.

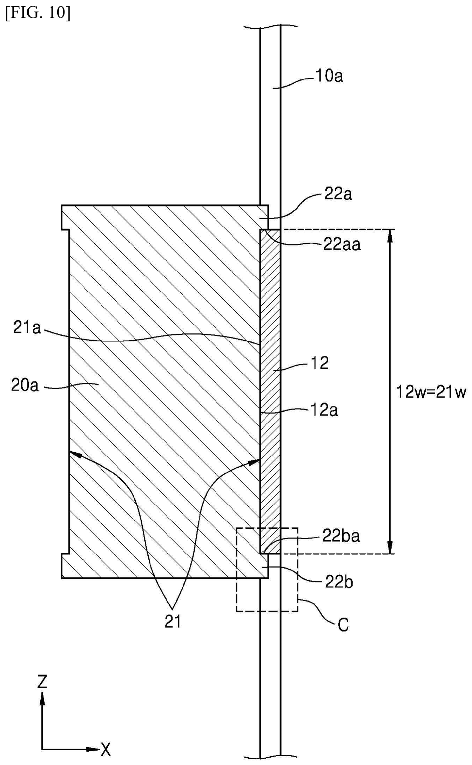

FIG. 10 is a cross-sectional view along line I-I' in FIG. 9.

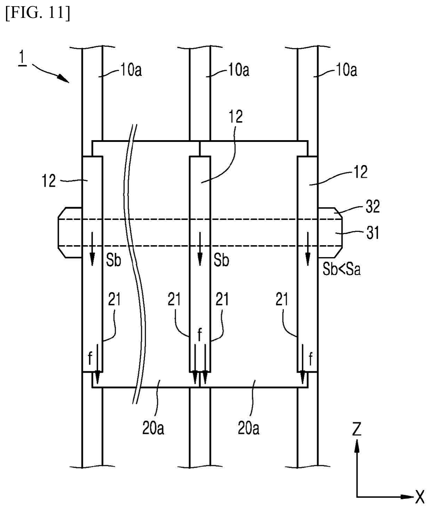

FIG. 11 is a view illustrating a magnitude of shear load applied to a fixing rod when the electrode block has a first groove according to an embodiment of the present invention.

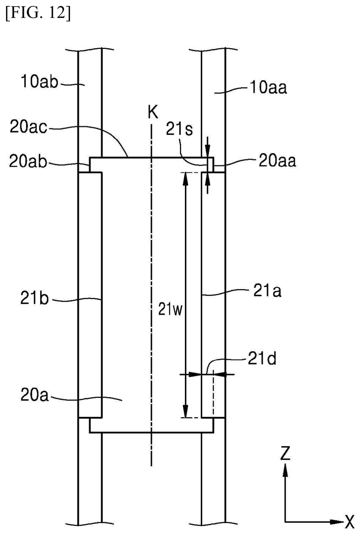

FIG. 12 is a view illustrating one electrode block and two electrode plates in contact with opposite surfaces of the electrode block.

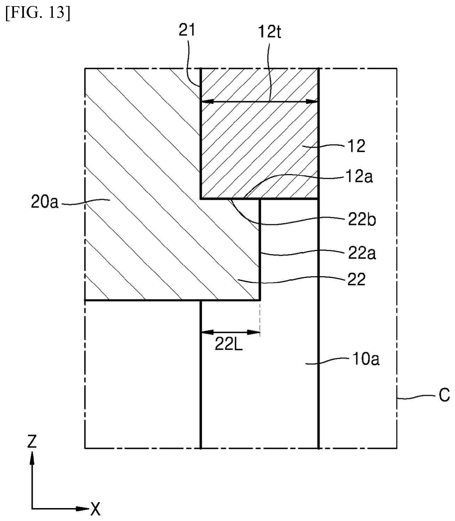

FIG. 13 is an enlarged view of part C of FIG. 10 which illustrates a protrusion.

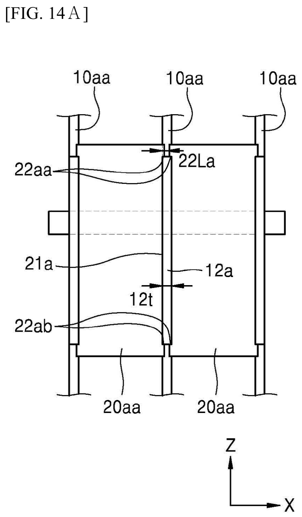

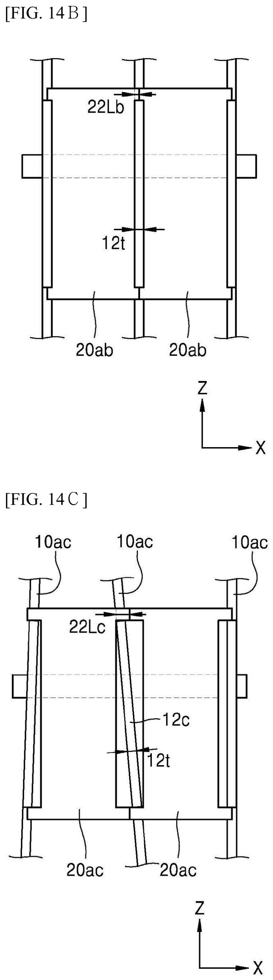

FIG. 14 shows views illustrating a connection structure between the electrode block and a contact portion that varies according to a length of the protrusion.

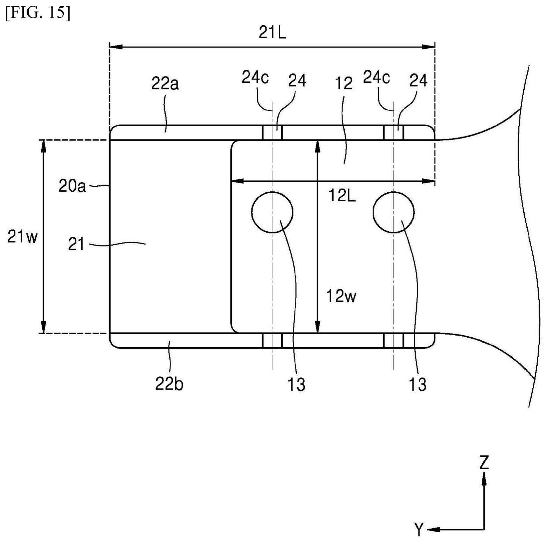

FIG. 15 is a view illustrating an area of a contact portion when the electrode block has the first groove according to an embodiment of the present invention.

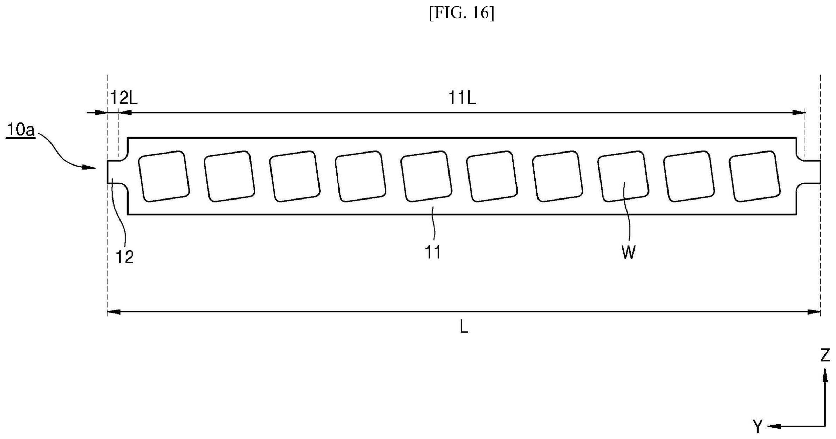

FIG. 16 is a view illustrating an example of the number of substrates loaded on the electrode plate according to an embodiment of the present invention.

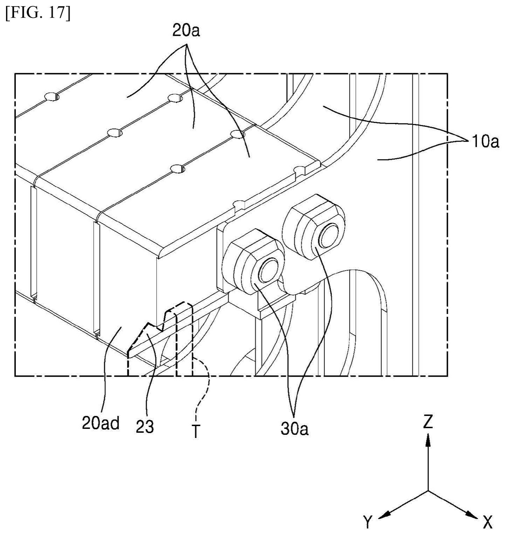

FIG. 17 is a view illustrating a portion at which a device for moving a boat apparatus comes into contact with the boat apparatus when the electrode block has the first groove and an area of the contact portion is smaller than an area of the first groove according to an embodiment of the present invention.

### [Best Mode]

One embodiment of the present invention provides a boat apparatus including a plurality of electrode plates which are disposed to be spaced apart from each other and between which a plurality of substrates are loaded, a plurality of electrode blocks which support a plurality of electrode plates having the same polarity among the plurality of electrode plates and each have a first groove, which is in contact with one of the plurality of electrode plates having the same polarity, formed in each of opposite surfaces; and a fixing part fastened to pass through the plurality of electrode plates and the plurality of electrode blocks.

### [Modes of the Invention]

Since various transformations can be applied to the present invention, which can have various embodiments, specific embodiments will be illustrated in the drawings and described in detail in the detailed description. However, it should be understood that this is not intended to limit the present invention to specific embodiments, which includes all transformations, equivalents, and substitutes included in the spirit and scope of the present invention. In the description of the present invention, like reference numerals refer to like components even when illustrated in different embodiments.

Hereinafter, embodiments of the present invention will be described in detail with reference to the accompanying drawings, wherein like reference numerals refer to the same or corresponding components throughout the drawings, and redundant description thereof will be omitted.

In the following embodiments, the terms "first," "second," and the like do not have limiting meanings but are used for the purpose of distinguishing one component from another component.

In the following embodiments, expressions used in the singular such as "a," "an," and "the" are intended to include the plural forms as well, unless the context clearly indicates otherwise.

In the following embodiments, it will be understood that terms such as "including," "comprising," and "having" specify the presence of stated features or components, but do not preclude the presence or addition of one or more other features or components.

In the drawings, components may be exaggerated or reduced in size for convenience of description. For example, the sizes and thicknesses of the respective components shown in the drawings are arbitrarily shown for convenience of description, and thus the present invention is not necessarily limited thereto.

When a certain embodiment may be implemented differently, a specific process order may be performed differently from the described order. For example, two consecutively described processes may be performed substantially at the same time or may be performed in an order opposite to the described order.

The terms used herein are merely used to describe specific embodiments and are not intended to limit the disclosure. In the present application, the word "comprise" or "has" is used to specify existence of a feature, number, process, operation, constituent element, part, or combination thereof, and it will be understood that existence or additional possibility of one or more other features, numbers, processes, operations, constituent elements, parts, or combinations thereof is not excluded in advance.

In the following embodiments, it will be understood that when an element such as a layer, film, region, or substrate is referred to as being connected to another element, it can be directly connected to the other element or intervening elements may also be present. For example, in the present specification it will be understood that when an element such as a layer, film, region, or substrate is referred to as being electrically connected to another element, it can be electrically connected directly to the other element or intervening elements may also be present.

Hereinafter, a boat apparatus according to an embodiment of the present invention will be described with reference to FIGS. 5 to 17.

FIG. 5 is a perspective view illustrating a boat apparatus 1 according to one embodiment of the present invention. FIG. 6 is an enlarged perspective view of part A of FIG. 5 which illustrates an end portion of the boat apparatus 1 according to one embodiment of the present invention.

Referring to FIGS. 5 and 6, the boat apparatus 1 may include electrode plates 10, electrode blocks 20, and fixing parts 30.

The electrode plates 10 may be disposed to be spaced apart from each other and may serve to load a plurality of substrates W therebetween, and the boat apparatus 1 may include a plurality of electrode plates 10. One electrode plate 10a and an adjacent electrode plate 10b may have different polarities. For example, the polarity of one electrode plate 10a may be positive (+), and the polarity of the adjacent electrode plate 10b may be negative (-). That is, the electrode plates 10a having the same polarity may be disposed with the electrode plate 10b having different polarity interposed therebetween.

The electrode plate 10 may include a substrate loading portion 11 and contact portions 12.

The substrate W may be attached to or detached from the substrate loading portion 11. The plurality of substrates W may be mounted in a longitudinal direction of the substrate loading portion 11.

The contact portions 12 are formed at both end portions of the electrode plate 10 and may be a portion of the electrode plate 10 that includes a surface in contact with the electrode block 20 to be described below. Referring to FIG. 5, a width 12w of the contact portion may be smaller than a width 11w of the substrate loading portion.

The electrode block 20 may support a plurality of electrode plates 10a having the same polarity among the plurality of electrode plates 10. In addition, the boat apparatus 1 may include a plurality of electrode blocks 20. Referring to FIG. 5, the electrode plate 10 and the electrode block 20 may be connected through the contact portion 12.

A plurality of electrode blocks 20a supporting the plurality of electrode plates 10a having the same polarity may be arranged in a line. Referring to FIG. 6, the plurality of electrode blocks 20a supporting the plurality of electrode plates 10a that are positive (+) or negative (-) electrodes may be arranged in a line in an X-axis direction. Meanwhile, a plurality of electrode blocks 20b supporting a plurality of electrode plates 10b that are negative (-) or positive (+) electrodes may be arranged in a line in the X-axis direction.

FIG. 7 is a view illustrating some of the plurality of electrode blocks 20a and some of the plurality of electrode plates 10a which have the same polarity and are connected thereto.

The electrode block 20 may include a conductive material. Meanwhile, referring to FIG. 7, the electrode block 20a may be located between two adjacent electrode plates 10a having the same polarity. In other words, the electrode plates 10a having the same polarity may be in contact with opposite side surfaces of the electrode block 20a. Accordingly, the plurality of electrode plates 10a which have the same polarity and are spaced an interval from each other may be electrically connected through the plurality of electrode blocks 20a. Thus, the plurality of electrode plates 10a having the same polarity may be electrically connected to each other.

Components that may be included in the electrode block 20 will be described below.

FIG. 8 is an enlarged perspective view of part B of FIG. 6 which illustrates the electrode plate 10a, the electrode block 20a, and a fixing part 30a. FIG. 9 is a view illustrating a structure in which one electrode plate 10a among the plurality of electrode plates is connected to one electrode block 20a among the plurality of electrode blocks.

The fixing part 30 may be fastened to pass through the plurality of electrode plates 10 and the plurality of electrode blocks 20. Referring to FIGS. 8 and 9, the fixing part 30a may include a fixing rod 31 and a fixing bolt 32.

The fixing rod 31 may pass through the plurality of electrode plates 10a having the same polarity and the plurality of electrode blocks 20a. A longitudinal direction of the fixing rod 31 may be perpendicular to a surface on which the electrode plate 10a and the electrode block 20a are in contact with each other. A shape of a cross section of the fixing rod 31 is not particularly limited. In an embodiment, as shown in FIGS. 8 and 9, the shape of the cross section of the fixing rod 31 may be a circular shape. A hole 13 through which the fixing rod 31 may pass may be formed in an end portion of the electrode plate 10a, more preferably, in the contact portion 12 and the electrode block 20a (see FIG. 15). A shape of the hole 13 may correspond to the shape of the cross section of the fixing rod 31. The fixing rod 31 may pass through the hole 13 formed in the plurality of electrode plates 10a having the same polarity and the plurality of electrode blocks 20a. Accordingly, the plurality of electrode plates 10a having the same polarity may be aligned, and the electrode blocks 20a may also be aligned in a line in the longitudinal direction of the fixing rod 31.

The fixing bolts 32 may be fastened to both end portions of the fixing rod 31. Accordingly, the plurality of electrode plates 10a having the same polarity and the plurality of electrode blocks 20a may be fixed in close contact with each other to easily move the plurality of substrates W loaded on the electrode plates. In addition, damage caused by vibration can be reduced when the boat apparatus 1 is lifted and moved.

Materials of the fixing rod 31 and the fixing bolt 32 are not particularly limited. In one embodiment, the materials of the fixing rod 31 and the fixing bolt 32 may include ceramics. Accordingly, a volume change according to a temperature change is minimized, thereby preventing damage to parts due to thermal expansion of the fixing part 30a in a high-temperature chamber.

A method of fastening the fixing rod 31 and the fixing bolt 32 is not particularly limited. In one embodiment, the fixing rod 31 and the fixing bolt 32 may be screw-coupled.

Meanwhile, there may be a plurality of fixing parts 30a and a plurality of holes 13 formed in the contact portion 12 and the electrode block 20a to correspond to the plurality of fixing parts 30a (see FIG. 15).

Hereinafter, a structure in which the electrode block 20a and the electrode plate 10a are connected will be described.

FIG. 10 is a cross-sectional view along line I-I' in FIG. 9. FIG. 11 is a view illustrating a magnitude S of shear load applied to the fixing rod 31 when the electrode block 20a has a first groove 21 according to an embodiment of the present invention.

In the boat apparatus 1 according to the embodiment of the present invention, the first groove 21 in contact with one of the plurality of electrode plates 10a having the same polarity may be formed in each of opposite surfaces of the electrode block 20a0.

The first groove 21 may be formed in each of opposite side surfaces of the electrode block 20a facing the electrode plates 10a. A shape of the first groove 21 may be a shape corresponding to the electrode plate 10a in contact with the electrode block 20a, specifically, the contact portion 12.

The contact portion 12 may be inserted into the first groove 21 and may be supported by the electrode block 20a. That is, by inserting the contact portion 12 into the first groove 21 of the electrode block 20a, the electrode block 20a may support the electrode plate 10a.

An end portion 12a of the contact portion 12 may be disposed at an inner side 21a of the electrode block 20a. Specifically, the end portion 12a of the contact portion 12 may be in contact with a bottom portion of the first groove 21. The width 12w of the contact portion may be equal to a width 21w of the first groove. Accordingly, the contact portion 12 may be inserted into and fixed to the first groove 21.

The effect of the presence of the first groove 21 according to an embodiment of the present invention will now be described in comparison with a conventional boat apparatus 100.

As shown in FIG. 2, in the case of the conventional boat apparatus 100 in which an electrode block does not have a first groove, the entire weight of an electrode plate 110 is applied to a fixing rod 131. However, as shown in FIG. 11, when the electrode block 20a has the first groove 21 according to the embodiment of the present invention, the electrode block 20a may support the electrode plate 10a when the contact portion 12 is inserted into the first groove 21, and the weight of the electrode plate 10a may be applied to the electrode block 20a to a certain extent f. Therefore, in the boat apparatus 1 in which the electrode block 20a has the first groove 21, a magnitude Sb of shear load acting on the fixing rod 31 by a weight of the electrode plate 10a is smaller than a magnitude Sa of shear load acting on the fixing rod 131 by a weight of the electrode plate 110 in the conventional boat apparatus 100 in which the electrode block does not have the first groove (Sb<Sa). A magnitude S of shear load acting on the fixing rod 31 is reduced, thereby preventing damage to the fixing rod 31.

Meanwhile, even when the electrode block 20a and the electrode plate 10a are fixed in close contact with each other by the fixing bolt 32, the fastening between the fixing bolt 32 and the fixing rod 31 may become loose due to vibration or the like during a process of lifting and moving the boat apparatus 1 to a chamber.

In the above case, in the case of the conventional boat apparatus 100 in which the electrode block does not have the first groove, a space may be generated between the electrode block 120 and the electrode plate 110, and an impact due to friction or collision may be generated between the electrode block 120 and the electrode plate 110.

However, when the electrode block 20a has the first groove 21 according to the embodiment of the present invention, even when the fastening between the fixing bolt 32 and the fixing rod 31 becomes loose due to vibration or the like during a process of lifting and moving the boat apparatus 1 to a chamber, the electrode plate 10a may be fixed to the electrode block 20a by inserting the contact portion 12 into the first groove 21, thereby reducing an impact due to friction or collision between the electrode block 20a and the electrode plate 10a, and preventing damage to the electrode block 20a and the electrode plate 10a due to the impact.

FIG. 12 is a view illustrating one electrode block 20a and two electrode plates 10a in contact with opposite surfaces of the electrode block 20a.

Opposite surfaces of the electrode block 20a with which the electrode plates 10a are in contact may be symmetrical to each other. Referring to FIG. 12, with respect to a center of the electrode block 20a as a symmetry axis K, a first surface 20aa corresponding to an electrode plate 10aa may be symmetrical to a second surface 20ab corresponding to an electrode plate 10ab, which has the same polarity and is adjacent to the electrode plate 10aa, with the electrode block 20a interposed therebetween. Specifically, a width 21w and a depth 21d of a first groove 21a formed in the first surface 20aa, and a distance 21s by which the first groove 21a is spaced apart from an upper end 20ac of the electrode block 20a may be equal to a width and a depth of a first groove 21b formed in the second surface 20ab, and a distance by which the first groove 21b is spaced apart from the upper end 20ac of the electrode block 20a. Furthermore, shapes of cross sections of the plurality of electrode blocks 20a included in the boat apparatus 1 according to the embodiment of the present invention may all be the same. Accordingly, the plurality of electrode plates 10a are aligned, thereby preventing damage to the fixing part 30a.

FIG. 13 is an enlarged view of part C of FIG. 10 which illustrates a protrusion 22.

The electrode block 20a may further include the protrusion 22 that forms a step with the first groove 21 and supports the contact portion 12.

Referring to FIG. 10, the protrusion 22 may be formed on one surface of the electrode block 20a facing the electrode plate 10a. Referring to FIG. 13, one surface 22a of the protrusion 22 may form a step with the bottom portion of the first groove 21 so that the protrusion 22 may have a protruding shape. The other surface 22b of the protrusion 22 may be in contact with the one surface 12a of the contact portion 12 to support the contact portion 12.

Accordingly, since a weight of the electrode plate 10a is applied to the protrusion 22 to a certain extent, the magnitude S of shear load acting on the fixing rod 31 due to the weight of the electrode plate 10a can be reduced. By reducing the magnitude S of shear load acting on the fixing rod 31, damage to the fixing rod 31 is prevented.

A plurality of protrusions 22 may be included, and each protrusion 22 may be formed at one of an upper end portion and a lower end portion of the electrode block 20a. Referring to FIG. 10, one surface 22aa of the protrusion 22a formed on at the upper end portion of the electrode block 20a and one surface 22ba of the protrusion 22b formed at the lower end portion of the electrode block 20a may both be in contact with the contact portion 12. Meanwhile, the contact portion 12 can be fixed by being interposed between the plurality of protrusions 22. Specifically, the contact portion 12 may be fixed in contact with the plurality of protrusions 22 and the first groove 21, thereby minimizing an impact due to friction or collision between the electrode block 20a and the electrode plate 10a, and preventing damage to the electrode block 20a and the electrode plate 10a due to the impact.

FIG. 14 shows views illustrating a connection structure between the electrode block 20a and the contact portion 12 that varies according to a length of the protrusion 22.

A length 22L of the protrusion may be 0.5 times or less a thickness 12t of the contact portion. In other words, referring to FIG. 13, a width of one surface 22b of the protrusion 22 in contact with the contact portion 12 may be smaller than or equal to half the thickness 12t of the contact portion.

Referring to FIG. 14, in the case of FIG. 14A in which a length 22La of the protrusion is smaller than 0.5 times the thickness 12t of the contact portion, the contact portion 12a may be fixed in contact with all of one surface 22aa of the protrusion formed at the upper end portion of two electrode blocks 20aa adjacent to each other with the contact portion 12a interposed therebetween, one surface 22ab of the protrusion formed at the lower end portion of the two electrode blocks 20aa, and the bottom portion of the first groove 21a, thereby obtaining all of the above-described effects. In addition, adjacent electrode plates 10aa having the same polarity may be electrically connected to each other. This also applies to the case of FIG. 14B in which a length 22Lb of the protrusion is 0.5 times the thickness 12t of the contact portion.

However, the case of FIG. 14C in which a length 22Lc of the protrusion is greater than 0.5 times the thickness 12t of the contact portion may be different. In the case of FIG. 14C, a contact portion 12c may not be fixed because the contact portion 12c is not in complete contact with two electrode blocks 20ac adjacent to each other with the contact portion 12c interposed therebetween. In addition, adjacent electrode plates 10ac having the same polarity may not be smoothly electrically connected to each other.

Accordingly, since the length 22L of the protrusion is smaller than 0.5 times the thickness 12t of the contact portion, the contact portion 12 may be completely fixed between two adjacent electrode blocks 20a, and adjacent electrode plates 10a having the same polarity may be electrically connected to each other.

FIG. 15 is a view illustrating an area of the contact portion 12c when the electrode block 20a has the first groove 21 according to an embodiment of the present invention. FIG. 16 is a view illustrating an example of the number of substrates W loaded on the electrode plate 10a according to an embodiment of the present invention.

In the boat apparatus 1 according to the embodiment of the present invention, the area of the contact portion 12 may be smaller than an area of the first groove 21. Specifically, referring to FIG. 15, when the width 12w of the contact portion is equal to the width 21w of the first groove, a length 12L of the contact portion may be smaller than a length 21L of the first groove.

The effect of the area of the contact portion 12 being smaller than the area of the first groove 21 will now be described in comparison with the conventional boat apparatus 100.

Referring to FIG. 3, in the conventional boat apparatus 100 in which the electrode block does not have the first groove, the entirety of one surface of the electrode block 120 is in contact with one end portion of the electrode plate 110 in order for the fixing part 130 to support the electrode plate 110 and the electrode block 120 as stably as possible.

However, when the electrode block 20a has the first groove 21 according to the embodiment of the present invention, as shown in FIG. 15, since the contact portion 12 is inserted into the first groove 21 and supported and fixed, even when an area of the contact portion 12 is not equal to an area of one surface of the electrode block 20a facing the electrode plate 10a, the fixing part 30a can stably support the electrode plate 10a and the electrode block 20a. Therefore, the area of the contact portion 12 may be smaller than the area of the first groove 21.

When a total length L of the electrode plate 10a (see FIG. 16) is constant, like the total length of the electrode plate 110 in the conventional boat apparatus 100 (see FIG. 4), as the area of the contact portion 12 decreases, more and more substrates W can be loaded on one electrode plate 10a. The total length L of the electrode plate is the sum of the lengths 12L of both end portions of the contact portion and a length 11L of the substrate loading portion. That is, when the total length L of the electrode plate is constant, the length 11L of the substrate loading portion may be increased when the length 12L of the contact portion is decreased. Accordingly, more substrates W can be loaded on one electrode plate 10a.

For example, in a case in which the entirety of one surface of the electrode block 120 is in contact with one end portion of the electrode plate 10 as in the conventional boat apparatus 100 in which the electrode block does not have the first groove (see FIG. 3), as shown in FIG. 4A, a total of nine substrates W may be loaded in a space 111 in which the substrate W may be loaded. However, since the electrode block 20a has the first groove 21 according to the embodiment of the present invention, when an area of the contact portion 12 is smaller than an area of the first groove 21 (see FIG. 15), as shown in FIG. 16, a total of ten substrates W may be loaded on the substrate loading portion 11. That is, in the case of FIG. 16, one more substrate W may be loaded as compared to the case of FIG. 4.

That is, as more and more substrates W are loaded on one electrode plate 10a, the number of substrates W that can be transported at one time by the boat apparatus 1 in a chamber can be increased, thereby increasing a production amount of solar cells.

Meanwhile, in one embodiment, the length 12L of the contact portion may be 0.5 times or more the length 21L of the first groove. In other words, an area of the contact portion 12 may be 0.5 times or more an area of the first groove 21.

Accordingly, a space on the electrode block 20a and the contact portion 12 in which the fixing rod 31 is disposed can be stably secured. Specifically, by securing a certain distance between the hole 13 formed in the electrode block 20 and one surface of the electrode block 20, damage to the electrode block 20 can be prevented. In addition, by securing a certain distance between the hole 13 formed in the contact portion 12 and an end of the contact portion 12, damage to the contact portion 12 can be prevented.

Since the length 12L of the contact portion is 0.5 times or more the length 21L of the first groove, the fixing rod 31 may be located in equilibrium without being biased to one side on the electrode block 20a so that the fixing part 30a can more stably support the electrode plate 10a and the electrode block 20a. In addition, by securing a certain portion at which the contact portion 12 may be inserted into the first groove 21 and supported and fixed, the first groove 21 can effectively share the role of the fixing part 30a in supporting the electrode plate 10a and the electrode block 20a.

FIG. 17 is a view illustrating a portion at which a device T for moving a boat apparatus comes into contact with the boat apparatus 1 when the electrode block 20a has the first groove 21 and an area of the contact portion 12 is smaller than an area of the first groove 21 according to an embodiment of the present invention.

In the boat apparatus 1 according to the embodiment of the present invention, at least one electrode block 20ad among the plurality of electrode blocks 20a may further include a support 23 supported on the device T for moving a boat apparatus.

Referring to FIG. 17, at least one electrode block of the plurality of electrode blocks 20a may be, specifically, the electrode block 20ad disposed at an outermost side when the plurality of electrode blocks 20a are arranged in a line. The device T that picks up and lifts the boat apparatus 1 and moves the boat apparatus 1 into a chamber should come into contact with a portion of the boat apparatus 1 to pick up and lift the boat apparatus 1. In this case, the support 23 may be at a position at which contact between the device T for moving a boat apparatus and the boat apparatus 1 occurs.

When the device T for moving a boat apparatus lifts the boat apparatus 1, the entire load of the boat apparatus 1 may be applied to a position at which contact between the device T for moving a boat apparatus and the boat apparatus 1 occurs.

The effect of the presence of the support 23 will now be described in comparison with the conventional boat apparatus 100.

In the case of the conventional boat apparatus 100 in which the electrode block does not have the first groove, the entirety of one surface of the electrode block 120 is in contact with one end portion of the electrode plate 110. In this case, as shown in FIG. 1, when the device T for moving a boat apparatus picks up and lifts the boat apparatus 100, the device T is in contact with the electrode plate 110 as well as the electrode block 120. Since a thickness 100t of the electrode plate is relatively smaller than a thickness 120t of the electrode block, the electrode plate 110 may be damaged when contact between the device T for moving a boat apparatus and the boat apparatus occurs.

However, in the case of the boat apparatus 1 according to the embodiment of the present invention, the electrode block 20 may have the first groove 21, and the area of the contact portion 12 may be smaller than the area of the first groove 21. In this case, as shown in FIG. 17, when the device T for moving a boat apparatus picks up and lifts the boat apparatus 1, the device T may be in contact with only the support 23 formed on the electrode block 20ad. Accordingly, when the device T for moving a boat apparatus picks up and lifts the boat apparatus 1, damage to the electrode plate 10a can be prevented.

The electrode block 20a may include at least one second groove 24. The second groove 24 may serve as a passage through which a cleaning liquid flows outward when the boat apparatus 1 is washed. The second groove 24 may be formed in each of opposite surfaces of the electrode block 20a in which the first groove 21 is formed, may vertically meet with the first groove 21, and may be connected to a point of the electrode block 20a through which the fixing part 30a passes.

Referring to FIG. 9, the second groove 24 may be formed in each of opposite surfaces of the electrode block 20a in which the first groove 21 is formed. The second groove 24 may meet the first groove 21. That is, the second groove 24 may be connected to and communicate with the first groove 21.

The second groove 24 may vertically meet the first groove 21. Specifically, as shown in FIG. 15, when the first groove 21 is formed in a Y-axis direction, the second groove 24 may be formed in a Z-axis direction perpendicular to the Y-axis direction. The second groove 24 may be formed from an upper surface of the electrode block 20a, may be formed from a lower surface thereof, or may extend from the upper surface to the lower surface.

The second groove 24 may be connected to a point of the electrode block 20a through which the fixing part 30a passes. The point of the electrode block 20a through which the fixing part 30a passes is the hole 13 described above. That is, the second groove 24 may be connected to the hole 13. More specifically, referring to FIG. 15, a center of the hole 13 may be located on a central axis 24c of the second groove.

The second groove 24 may be connected to the point of the electrode block 20a through which the fixing rod 31 passes, and the fixing rod 31 may also pass through the contact portion 12 so that the second groove 24 may be disposed at a portion of the electrode block 20a with which the contact portion 12 is in contact.

At least one second groove 24 may be formed in the electrode block 20a. As described above, a plurality of fixing parts 30a and a plurality of holes 13 may be provided, and a plurality of second grooves 24 may also be provided to correspond to the plurality of holes 13.

A shape of a cross section of the second groove 24 may be a semicircle as shown in FIG. 9. A diameter of the semicircle (hereinafter referred to as "diameter of the second groove 24") may exceed 0.5 times the thickness 12t of the contact portion. Accordingly, a space may be formed between the electrode block 20a and the contact portion 12 due to the second groove 24.

The diameter of the second groove 24 may be smaller than a diameter of the hole 13. This is to ensure that the fixing rod 31 is stably fixed to the electrode block 20a to support the electrode block 20a and prevent damage to the electrode block 20a.

Since the second groove 24 is present, when the boat apparatus 1 is washed, a cleaning liquid that flows in between the first groove 21 and the contact portion 12, between the electrode block 20a and the fixing rod 31, and between the contact portion 12 and the fixing rod 31 can be quickly discharged through the second groove 24, thereby shortening a drying time after the boat apparatus 1 is washed.

The present invention has been described above with reference to embodiment shown in the drawings, but this is only an example. Those of ordinary skill in the art may fully understand that various modifications and other equivalent embodiments are possible from the embodiments. Therefore, the true technical protection scope of the present invention should be determined based on the appended claims.

Specific technical content described in the embodiment is an embodiment and does not limit the technical scope of the embodiment. In order to concisely and clearly describe the invention, descriptions of conventional general techniques and configurations may be omitted. In addition, the connection or connection members of lines between the components shown in the drawings are illustrative of functional connections and/or physical or circuit connections, and may be represented as a variety of functional connections, physical connections, or circuit connections that are replaceable or additional in an actual device. In addition, anything for which there is no specific mention such as "essential" or "importantly" may not be an essential component for the application of the present invention.

In the description of the invention and in the claims, "the" or similar referents may refer to both the singular and the plural unless otherwise specified. In addition, when a range is described in the embodiment, it includes the invention to which individual values within the range are applied (unless there is a description to the contrary), and each individual value constituting the range is described in the description of the invention. In addition, the operations constituting the method according to the embodiment may be performed in an appropriate order unless the order is explicitly stated or there is description to the contrary. The embodiments are not necessarily limited by the described order of the operations. The use of all examples or illustrative terms (e.g., "and the like") in the embodiment is merely for the purpose of describing the embodiment in detail, and unless limited by the claims, the scope of the embodiments is not limited by the above examples or exemplary terms. In addition, those skilled in the art will appreciate that various modifications, combinations, and changes may be made in accordance with design conditions and factors within the scope of the appended claims or their equivalents.

### [Industrial Applicability]

The present invention can be used in industries relating to boat apparatuses.

## Claims

1. A boat apparatus comprising:
a plurality of electrode plates which are disposed to be spaced apart from each other and between which a plurality of substrates are loaded;
a plurality of electrode blocks which support a plurality of electrode plates having the same polarity among the plurality of electrode plates and each have a first groove, which is in contact with one of the plurality of electrode plates having the same polarity, formed in each of opposite surfaces of the electrode block; and
a fixing part fastened to pass through the plurality of electrode plates and the plurality of electrode blocks.

2. The boat apparatus of claim 1, wherein the opposite surfaces of the electrode block with which the electrode plates are in contact are symmetrical to each other.

3. The boat apparatus of claim 1, wherein the electrode plate further includes a contact portion inserted into the first groove and supported by the electrode block, and
the electrode block further includes a protrusion configured to form a step with the first groove and support the contact portion.

4. The boat apparatus of claim 3, wherein an end portion of the contact portion is disposed inside the electrode block.

5. The boat apparatus of claim 3, wherein an area of the contact portion is smaller than an area of the first groove.

6. The boat apparatus of claim 3, wherein a length of the contact portion is 0.5 times or more a length of the first groove.

7. The boat apparatus of claim 3, wherein the protrusion is provided as a plurality of protrusions, each protrusion is formed at one of an upper end portion and a lower end portion of the electrode block, and
wherein the contact portion is fixedly interposed between the plurality of protrusions.

8. The boat apparatus of claim 3, wherein a length of the protrusion is 0.5 times or less a thickness of the contact portion.

9. The boat apparatus of claim 1, wherein at least one electrode block among the plurality of electrode blocks further includes a support supported on a device configured to move the boat apparatus.

10. The boat apparatus of claim 1, wherein the electrode block includes one or more second grooves which are each formed in one of opposite surfaces of the electrode block having the first groove, vertically meets the first groove, and is connected to a point of the electrode block through which the fixing part passes.
